# EUROPÄISCHE PATENTSCHRIFT

(11) **EP 3 822 689 B1**
(45) Veröffentlichungstag und Bekanntmachung des Hinweises auf die Patenterteilung: **25.05.2022**
(21) Anmeldenummer: 19209188.2
(22) Anmeldetag: 14.11.2019
(51) Int. Cl.: G02B 26/02, G01K 7/36, G01K 7/38

(54) **STRAHLVERSCHLUSS, LASERANORDNUNG UND ZUGEHÖRIGES BETRIEBSVERFAHREN**
BEAM SHUTTER, LASER ARRANGEMENT AND ASSOCIATED OPERATING METHOD
OBTURATEUR DE FAISCEAU, DISPOSITIF LASER ET PROCÉDÉ DE FONCTIONNEMENT ASSOCIÉ

(43) Veröffentlichungstag der Anmeldung: 19.05.2021
(73) Patentinhaber: TRUMPF Schweiz AG, 7214 Grüsch (CH)
(72) Erfinder: HERZOG, Teja, 7206 Igis (CH)
(74) Vertreter: Kohler Schmid Möbus Patentanwälte

(56) Entgegenhaltungen:
- EP-A2- 0 899 595
- WO-A2-03/048835
- JP-U- S5 763 240
- US-A1- 2003 019 937
- US-A1- 2014 353 920

## Beschreibung

Die Erfindung betrifft einen Strahlverschluss für einen Laserstrahl, eine Laseranordnung mit einer Laserlichtquelle und einem Strahlverschluss sowie ein Verfahren zum Betreiben einer Laseranordnung.

Bei aus dem Stand der Technik bekannten Laseranordnungen mit einer Laserlichtquelle zum Erzeugen eines Laserstrahls ist oft vorgesehen, dass beim Öffnen eines Sicherheitskreises (beispielsweise Unterbrechen einer Lichtschranke oder Öffnen einer Einhausung) eine reflektierende Optik in den Strahlengang des Laserstrahls eingeklappt wird. Die reflektierende Optik unterbricht dann den Weg des Laserstrahls zu einer Austrittsöffnung. Der Laserstrahl wird von der reflektierenden Optik abgelenkt und trifft typischerweise auf einen Absorber.

Es kann bei solchen Vorrichtungen mitunter vorkommen, dass sich die reflektierende Optik von einer Haltevorrichtung löst. Bei geringen Laserleistungen ist die passive Sicherheit des Materials der Haltervorrichtung, an der die reflektierende Optik fixiert ist, ausreichend, um zu gewährleisten, dass auch beim Verlust der Optik der Laserstrahl noch weiterhin unterbrochen wird. Bei hohen Laserleistungen kann demgegenüber die Haltevorrichtung ohne die reflektierende Optik den Strahl nicht dauerhaft aufhalten. Ein sicheres Verhindern des Austritts des Laserstrahls ist dann nicht mehr gewährleistet. Ein Fehlen der Optik sicher zu detektieren ist jedoch sehr schwierig.

Alternativ kann, insbesondere bei hohen Laserleistungen, eine reflektierende Optik zur aktiven Auskopplung von Laserstrahlung eingesetzt werden. Die reflektierende Optik wird in diesem Fall in den Laserstrahl eingeklappt, wenn Laserlicht emittiert werden soll. Wenn die reflektierende Optik nicht in den Strahlengang eingeklappt ist, trifft der Laserstrahl direkt auf einen Absorber. Damit bedeutet ein Verlust der reflektierenden Optik keinen Verlust der Lasersicherheit mehr. Fehlt die Optik und brennt der Laser durch eine Haltervorrichtung der reflektierenden Optik, so trifft der Strahl den Absorber, der der Laserleistung standhält. Bei der aktiven Auskopplung des Laserstrahls ist jedoch eine sehr hohe Genauigkeit bei der Positionierung der reflektierenden Optik im Strahlengang nötig, da der Laserstrahl beim Auskoppeln, etwa zum Zwecke einer Bearbeitung mit dem Laserstrahl, immer von dieser beweglichen Optik abgelenkt werden muss.

Ein Strahlverschluss mit einem Spiegel zum Auskoppeln eines Laserstrahls ist aus EP 0 899 595 A2 bekannt geworden. Der Spiegel ist auf einer geradlinig bewegbaren Haltevorrichtung angeordnet. Die Haltevorrichtung weist eine Spule auf, um die Haltevorrichtung gegenüber feststehenden Stabmagneten zu bewegen, wenn die Spule von einem Strom durchflossen wird. Um ein Abbremsen der Haltevorrichtung vor Erreichen zweier Endanschläge steuern zu können, ist an der Haltevorrichtung ein Stahlflügel angeordnet, der mit zwei Hall-Effekt-Schaltern zusammenwirkt, die 3 mm vor den jeweiligen Endpositionen der Haltevorrichtung angeordnet sein können.

Aus DE 10 2004 008 326 A1 ist ein Lichtschutzverschluss für optische Geräte, beispielsweise ein Mikroskop, bekannt geworden. Der Lichtschutzverschluss weist ein mit einer Motorwelle eines Schrittmotors verbundenes Verschlusselement zum Öffnen und Verschließen einer Blendenöffnung einer Befestigungseinheit auf. An der Befestigungseinheit kann ein Endlagensensor vorgesehen sein, um die Lage des Verschlusselements zu ermitteln.

DE 10 2016 101 231 B4 beschreibt einen Breitband-Laserverschluss umfassend eine schwarze Diamant-Absorberplatte, die in einem ferromagnetischen Rahmen gehalten ist, mittels dessen die Absorberplatte gleitend auf einem Kühlkörperblock bewegbar ist. Zur Positionsrückmeldung können zwei fixierte Drähte und ein mit dem Rahmen beweglicher Draht vorgesehen sein.

Aus WO 91/16652 A1 ist ein Verschluss für einen Lichtstrahl bekannt geworden, der ein flexibles Blatt aus ferromagnetischem Material umfasst. In einer ersten Stellung wird das Blatt von einem Magneten gegen einen Anschlag gezogen, so dass das Blatt den Lichtstrahl in eine Lichtfalle lenkt. Zur Freigabe des Lichtstrahls wird das Blatt von einem Elektromagneten von dem Anschlag weg gezogen.

DE 100 29 444 A1 beschreibt einen Shutter für einen Lichtstrahl einer Laserlichtquelle, der zwei gegenläufig bewegbare Bauteile zum Unterbrechen des Lichtstrahls aufweist. Zur Funktionsüberwachung kann in jedem der Bauteile ein Durchgang für einen Lichtstrahl einer Lichtschranke ausgebildet sein.

Aus US 2009/019937 A1 ist ein Scanmechanismus für einen Barcodescanner bekannt geworden. Der Scanmechanismus weist eine Spiegelbaugruppe mit einer Spiegelhalterung und einer Spiegeloberfläche auf. Die Spiegelhalterung ist schwenkbar gelagert. An der Spiegelhalterung kann ein Magnet angeordnet sein. Der Magnet kann mit einem Hall-Sensor zusammenwirken, um eine Positions- oder Geschwindigkeitserfassung zu ermöglichen.

WO 03/048835 A2 beschreibt einen mechanischen Lasershutter mit einer reflektierenden Platte, die einen Laserstrahl entweder durchlässt oder in einer Blockierposition auf einen Absorber lenkt. Zum Erfassen der Position des Shutters können optische Sensoren vorgesehen sein.

Aus US 2014/0353920 A1 ist ein Messsystem zur Überwachung eines Kugellagers bekannt. Das Messsystem weist einen Permanentmagneten auf, der an dem Kugellager befestigt ist. Ein Magnetfeld des Permanentmagneten nimmt in Abhängigkeit von der Temperatur ab. Eine Auswerteschaltung des Messsystems ist dazu eingerichtet, Signale von einem Magnetsensor zu erhalten. Die Auswerteschaltung kann dazu eingerichtet sein, Alarmsignale zu erzeugen, wenn die erfasste Temperatur einen Grenzwert überschreitet.

Es ist eine Aufgabe der Erfindung, einen Strahlverschluss anzugeben, der einen sicheren Betrieb einer Laserlichtquelle mit großer Leistung, insbesondere ein zuverlässiges Unterbrechen eines Laserstrahls, ermöglicht. Ferner ist es Aufgabe der Erfindung eine sicher betreibbare Laseranordnung und ein Betriebsverfahren für einen sicheren Betrieb der Laseranordnung anzugeben

Diese Aufgaben werden gelöst durch einen Strahlverschluss gemäß Anspruch 1, eine Laseranordnung gemäß Anspruch 10 und ein Betriebsverfahren gemäß Anspruch 12. Die jeweiligen Unteransprüche und die Beschreibung geben vorteilhafte Ausführungsformen und Varianten an.

Erfindungsgemäß ist ein Strahlverschluss für einen Laserstrahl vorgesehen. Der Strahlverschluss kann auch als ein Shutter bezeichnet werden. Der Strahlverschluss weist einen Grundkörper auf. An dem Grundkörper ist ein erster Magnetfeldsensor angeordnet. Der Strahlverschluss weist ferner einen relativ zu dem Grundkörper in eine Freigabestellung und eine Verschlussstellung verbringbaren Haltearm auf. An dem Haltearm sind eine reflektierende Optik zum Umlenken des Laserstrahls und ein Permanentmagnet angeordnet. Der Permanentmagnet ist typischerweise beabstandet von der reflektierenden Optik am Haltearm angeordnet. Vorzugsweise sind der Permanentmagnet und die reflektierende Optik an gegenüberliegenden Endbereichen des Haltearms angeordnet. Der Permanentmagnet erzeugt ein Magnetfeld, dessen Stärke bei Erwärmen des Permanentmagneten über eine erste Grenztemperatur abnimmt. In der Verschlussstellung des Haltearms ist der Permanentmagnet näher an dem ersten Magnetfeldsensor angeordnet als in der Freigabestellung des Haltearms. In der Verschlussstellung des Haltearms ist der Permanentmagnet vorzugsweise nächstmöglich am ersten Magnetfeldsensor angeordnet. Der Permanentmagnet kann beispielsweise aus Neodym-Eisen-Bor bestehen. Der Strahlverschluss weist eine Steuereinheit auf, welche dazu eingerichtet ist, eine Laserlichtquelle abzuschalten, wenn das von dem ersten Magnetfeldsensor gemessene Magnetfeld abnimmt, wobei ein vorbestimmter Schwellwert bezüglich der Stärke und/oder des Gradienten des Magnetfelds passiert werden.

Wenn sich der Haltearm in der Verschlussstellung befindet und der Permanentmagnet nicht über die erste Grenztemperatur erwärmt wurde, erkennt der erste Magnetfeldsensor anhand der Stärke des von dem Permanentmagneten erzeugten Magnetfelds, dass der Strahlverschluss sich in einem Zustand befindet, in dem ein Laserstrahl sicher aufgehalten werden kann.

Der Permanentmagnet ist über den Haltearm grundsätzlich thermisch an die reflektierende Optik bzw. einen Aufnahmeabschnitt des Haltearms für die reflektierende Optik gekoppelt. Falls die reflektierende Optik verloren gehen oder sonst einen Defekt erleiden sollte, erwärmt der Laserstrahl den Haltearm. Die Erwärmung des Haltearms überträgt sich auf den Permanentmagneten. Bei Erwärmung über die erste Grenztemperatur nimmt die Stärke des von dem Permanentmagneten erzeugten Magnetfelds ab. Bei Überschreiten der ersten Grenztemperatur führt mit anderen Worten eine vorübergehende (reversible) oder dauerhafte Änderung der Magnetisierung des Permanentmagneten zu einem abfallenden Sensorsignal des ersten Magnetfeldsensors. Wenn der erste Magnetfeldsensor erkennt, dass das von ihm erfasste Magnetfeld eine Mindeststärke nicht erreicht, bedeutet dies, dass entweder der Haltearm sich in der Freigabestellung befindet oder dass der Haltearm übermäßig erwärmt wurde. Diese Information kann ein Abschalten einer Laserlichtquelle veranlassen, um einen sicheren Zustand herbeizuführen. Dadurch dass im Gefahrenfall/Fehlerfall ein Signalverlust bzw. ein Signalabfall (und nicht ein Signalanstieg) festgestellt wird, kann ein gefährliches Versagen vermieden werden. Das Funktionsprinzip des erfindungsgemäßen Strahlverschlusses ist daher intrinsisch sicher. Der erfindungsgemäße Strahlverschluss ermöglicht insbesondere eine kontaktlose und verschleißfreie Überwachung des sicheren Verschließens des Strahlenwegs für den Laserstrahl.

Der erste Magnetfeldsensor ist typischerweise zum Messen einer Stärke eines Magnetfeldes ausgebildet. Alternativ oder zusätzlich kann der erste Magnetfeldsensor zum Messen eines zeitlichen und/oder räumlichen Gradienten der Stärke eines Magnetfeldes ausgebildet sein. Der erste Magnetfeldsensor kann ein induktiver Sensor sein.

Die reflektierende Optik ist vorzugsweise hochreflektierend ausgebildet. Insbesondere kann die reflektierende Optik dazu ausgebildet sein, wenigstens 98 %, bevorzugt wenigstens 99 %, besonders bevorzugt wenigstens 99,5 %, des auf sie treffenden Laserlichts einer Laserlichtquelle einer Laseranordnung mit dem Strahlverschluss zu reflektieren.

Der Haltearm ist typischerweise aus einem Material gefertigt, das auch bei hohen Temperaturen seine Form behält und den Laserstrahl auch ohne die reflektierende Optik unterbricht. Die erste Grenztemperatur des Permanentmagneten liegt typischerweise deutlich, insbesondere wenigstens 200 K, unter einer Temperatur, bei der sich der Haltearm zu verformen beginnt.

Bevorzugt ist der Permanentmagnet so ausgebildet, dass das von dem Permanentmagneten erzeugte Magnetfeld bei Erwärmen des Permanentmagneten über eine zweite Grenztemperatur vollständig verschwindet. Die zweite Grenztemperatur ist größer oder gleich der ersten Grenztemperatur. Wenn die zweite Grenztemperatur größer ist als die erste Grenztemperatur gibt es zwischen der ersten und der zweiten Grenztemperatur einen Abfallbereich des Magnetfeldes. Wenn die zweite Grenztemperatur gleich der ersten Grenztemperatur ist, fällt die Stärke des Magnetfeldes bei Überschreiten der beiden Grenztemperaturen sprunghaft ab. Die zweite Grenztemperatur ist insbesondere eine Curie-Temperatur des Permanentmagneten. Die zweite Grenztemperatur des Permanentmagneten liegt grundsätzlich unter der Schmelztemperatur eines Materials des Haltearms, vorzugsweise wenigstens 200 K, besonders bevorzugt wenigstens 300 K, ganz besonders bevorzugt wenigstens 400 K. Dadurch kann sichergestellt werden, dass der Permanentmagnet seine Magnetisierung verliert bevor der Haltearm zu schmelzen beginnt.

Besonders bevorzugt besteht der Haltearm aus CuCr1Zr. Dieses Material hat in Beschusstests mit Laserstrahlen auch bei sehr hohen Temperaturen, insbesondere mehrere hundert Kelvin über der Curie-Temperatur üblicher Permanentmagneten, noch die Form behalten und den Laserstrahl unterbrochen.

Es kann vorgesehen sein, dass der Haltearm in die Verschlussstellung vorgespannt ist. Dadurch kann erreicht werden, dass der Haltearm automatisch in die Verschlussstellung übergeht, wenn er nicht durch einen Antrieb aktiv in die Freigabestellung verbracht wird. Dies erhöht die Sicherheit für den Fall eines Defekts oder Ausfalls des Antriebs.

Es kann ein Anschlag für den Haltearm vorgesehen sein. Der Anschlag kann insbesondere die Verschlussstellung definieren bzw. ein Verbringen des Haltearms über die Verschlussstellung hinaus unterbinden. Zusammen mit einer Vorspannung kann durch den Anschlag das Übergehen des Haltearms in die Verschlussstellung noch sicherer gestaltet werden.

Der Haltearm kann drehbar an dem Grundkörper gelagert sein. Eine Drehlagerung kann besonders einfach eingerichtet werden. Der Haltearm kann mithin zwischen der Verschlussstellung und der Freigabestellung verschwenkt werden. Zum Drehen/Verschwenken des Haltearms kann ein Elektromotor, insbesondere ein Schrittmotor, vorgesehen sein. Insbesondere kann der Haltearm auf einer Welle des Elektromotors befestigt sein. Auf diese Weise wird ein besonders einfach aufgebauter Strahlverschluss erhalten.

Die reflektierende Optik kann einen Spiegel aufweisen. Der Spiegel ist vorzugsweise mit dem Haltearm verklebt. Dies vereinfacht die Fertigung des Strahlverschlusses.

Vorteilhafterweise ist der erste Magnetfeldsensor als ein Hall-Sensor ausgebildet. Ein Hall-Sensor erlaubt eine zuverlässige und präzise Messung eines auf ihn wirkenden Magnetfeldes. Alternativ oder zusätzlich kann der erste Magnetfeldsensor einen magneto-resistiven Effekt ausnutzen.

Besonders bevorzugt ist vorgesehen, dass an dem Grundkörper ein zweiter Magnetfeldsensor angeordnet ist. In der Freigabestellung des Haltearms ist der Permanentmagnet näher an dem zweiten Magnetfeldsensor angeordnet als in der Verschlussstellung des Haltearms. In der Freigabestellung des Haltearms ist der Permanentmagnet vorzugsweise nächstmöglich am zweiten Magnetfeldsensor angeordnet. Von dem zweiten Magnetfeldsensor kann erkannt werden, ob sich der Haltearm in der Freigabestellung befindet. Damit kann für den Fall, dass der erste Magnetfeldsensor kein ausreichend starkes Magnetfeld misst, festgestellt werden, ob der Halterarm (gewollt) in die Freigabestellung verbracht wurde, oder ob der Permanentmagnet (ungewollt) über seine erste bzw. zweite Grenztemperatur erwärmt wurde.

Der zweite Magnetfeldsensor ist typischerweise zum Messen einer Stärke eines Magnetfeldes ausgebildet. Alternativ oder zusätzlich kann der zweite Magnetfeldsensor zum Messen eines zeitlichen und/oder räumlichen Gradienten der Stärke eines Magnetfeldes ausgebildet sein. Der zweite Magnetfeldsensor kann als ein Hall-Sensor ausgebildet sein. Der zweite Magnetfeldsensor kann einen magneto-resistiven Effekt ausnutzen. Der zweite Magnetfeldsensor kann ein induktiver Sensor sein.

Der erste und/oder der zweite Magnetfeldsensor können mehrere Subsensoren aufweisen. Mit solchen Magnetfeldsensoren können räumliche Gradienten des von dem Permanentmagneten erzeugten Magnetfelds erfasst werden. Die Subsensoren können in einer Matrixstruktur angeordnet sein, insbesondere mit wenigstens einer Spalte und wenigstens zwei Zeilen von Subsensoren. Die wenigstens zwei Zeilen sind typischerweise so angeordnet, dass der Permanentmagnet beim Verbringen des Haltearms zwischen der Verschlussstellung und der Freigabestellung mehrere der Zeilen überstreicht.

In den Rahmen der Erfindung fällt auch eine Laseranordnung mit einer Laserlichtquelle zum Erzeugen eines Laserstrahls und mit einem im Strahlengang des Laserstrahls angeordneten oben beschriebenen, erfindungsgemäßen Strahlverschluss. Die Laserlichtquelle kann eine Laserleistung von wenigstens 100 W, insbesondere wenigstens 1 kW besitzen. Der Laserstrahl trifft in der Verschlussstellung des Haltearms auf die reflektierende Optik. Die Vorteile des erfindungsgemäßen Strahlverschlusses können bei einer solchen Laseranordnung nutzbar gemacht werden. Insbesondere ist es bei großen Laserleistungen besonders wichtig, dass der Laserstrahl zuverlässig unterbrochen werden kann. Der erfindungsgemäße Strahlverschluss vermag dies zu leisten.

Eine Sicherheitslogik einer bestehenden Laseranordnung muss bei Verwendung des erfindungsgemäßen Strahlverschlusses typischerweise nicht angepasst werden. Mithin bleibt eine bestehende Wahrheitstabelle im Zustandsdiagramm für den Strahlverschluss gültig. Die Wahrheitstabelle kann insbesondere Zustände beschreiben, in denen der Laserstrahl von dem Strahlverschluss unterbrochen werden muss, beispielsweise wenn ein Sicherheitskreis der Laseranordnung unterbrochen bzw. geöffnet wird.

Die Sicherheitslogik der Laseranordnung bzw. des Strahlverschlusses ist typischerweise so aufgebaut, dass ein Fehlen des Signals am ersten Magnetfeldsensor durch den Permanentmagneten, der am Haltearm fixiert ist, zu einem Abschalten des Lasers führt, es sei denn es erfolgt ein regulärer Betrieb (Haltearm in Freigabestellung, Sicherheitskreis geschlossen). Wird der Strahlverschluss geöffnet (Haltearm in Freigabestellung) und Laserlicht emittiert, so bewegt sich der am Haltearm fixierte Magnet weg vom ersten Magnetfeldsensor und dessen Signal fällt ab. Wird der Strahlverschluss geschlossen (Haltearm in Verschlussstellung) wird die Nähe von Permanentmagnet und erstem Magnetfeldsensor detektiert. Wird der Permanentmagnet über die erste Grenztemperatur, insbesondere über die zweite Grenztemperatur, erhitzt, verschwindet die (spontane oder gerichtete) Magnetisierung von Kristallbereichen und der erste Magnetfeldsensor stellt einen Signalabfall fest. Daraufhin kann der Laser abgeschaltet werden, noch bevor der Haltearm geschmolzen oder vom Laser perforiert wird. Auch ein Verlust des Permanentmagneten oder ein Ausfall des ersten Magnetfeldsensors stellt keinen gefährlichen Zustand dar, da ein fehlendes Signal immer (Ausnahme: regulärer Betrieb) ein Einschalten der Laserlichtquelle verhindert.

Die Laseranordnung umfasst typischerweise auch einen Absorber, auf welchen der Laserstrahl von der reflektierenden Optik gelenkt wird, wenn sich der Haltearm in der Verschlussstellung befindet.

Es kann vorgesehen sein, dass der Haltearm eines erfindungsgemäßen Strahlverschlusses die reflektierende Optik flächig hintergreift. Der Haltearm weist mithin - betrachtet aus Richtung eines auf die reflektierende Optik treffenden Laserstrahls der Laseranordnung - einen hinter der reflektierenden Optik angeordneten Flächenabschnitt auf. Mit anderen Worten blockiert der Haltearm in der Verschlussstellung auch bei Fehlen der reflektierenden Optik den Strahlengang des Laserstrahls.

Der Haltearm des Strahlverschlusses ist besonders bevorzugt so ausgebildet ist, dass er bei Fehlen der reflektierenden Optik einem unmittelbaren Auftreffen des Laserstrahls standhält, bis der Permanentmagnet über die erste Grenztemperatur, insbesondere über die zweite Grenztemperatur, erwärmt worden ist. Dadurch kann sichergestellt werden, dass auch ohne die reflektierende Optik der Laserstrahl von dem Strahlverschluss sicher unterbrochen bzw. aufgehalten werden kann.

In den Rahmen der vorliegenden Erfindung fällt auch ein Verfahren zum Betreiben einer oben beschriebenen, erfindungsgemäßen Laseranordnung. Das Verfahren umfasst die Schritte
a) Verbringen des Haltearms in die Verschlussstellung,
b) Betreiben der Laserlichtquelle und Messen einer Stärke und/oder eines Gradienten eines Magnetfeldes mit dem ersten Magnetfeldsensor,
c) Abschalten der Laserlichtquelle, wenn das von dem ersten Magnetfeldsensor gemessene Magnetfeld abnimmt.

Im Betrieb sendet die Laserlichtquelle einen Laserstrahl aus. Der Betrieb der Laserlichtquelle kann vor der Durchführung von Schritt a) begonnen haben. Durch Schritt a) wird sichergestellt, dass der Laserstrahl den Strahlverschluss nicht passieren kann. Durch die Messung der Stärke und/oder des Gradienten des Magnetfelds mit dem ersten Magnetfeldsensor wird überwacht, ob der Strahlverschluss sich noch in einem Zustand befindet, in welchem er den Laserstrahl sicher aufhalten kann. Wenn das von dem ersten Magnetfeldsensor gemessene Magnetfeld abnimmt, ist davon auszugehen, dass der Laserstrahl von dem Strahlverschluss nicht mehr aufgehalten wird oder nicht mehr lange aufgehalten werden kann. Es wird daher die Laserlichtquelle abgeschaltet, wobei das Abschalten der Laserlichtquelle von weiteren Bedingungen abhängig sein kann. Das erfindungsgemäße Verfahren erlaubt einen Betrieb der erfindungsgemäßen Laseranordnung mit einer erhöhten Sicherheit. Insbesondere kann auf diese Weise ein Betrieb der Laserlichtquelle beendet werden, bevor im Falle eines Verlusts der reflektierenden Optik der Haltearm den Laserstrahl nicht mehr aufhalten kann.

Im Schritt b) kann der Permanentmagnet über die erste Grenztemperatur, insbesondere über die zweite Grenztemperatur, erwärmt werden. Bei Überschreiten der ersten Grenztemperatur verringert sich die Magnetisierung des Permanentmagneten bzw. verschwindet bei Überschreiten der zweiten Grenztemperatur vollständig, so dass auf eine thermische Überlastung des Haltearms, an dem der Permanentmagnet befestigt ist, geschlossen werden kann. Die zweite Grenztemperatur ist typischerweise eine Curie-Temperatur des Permanentmagneten.

Der erste Magnetfeldsensor misst in Schritt b) vorzugsweise den zeitlichen Verlauf einer Stärke und/oder eines Gradienten (der Stärke) eines Magnetfeldes. Eine das Abschalten in Schritt c) auslösende Abnahme des Magnetfeldes wird daran erkannt, dass das von dem ersten Magnetfeldsensor gemessene Magnetfeld einen vorbestimmten Schwellwert bezüglich der Stärke und/oder des Gradienten des Magnetfelds passiert.

Der Schwellwert, bezüglich der Stärke kann relativ zur nicht verringerten (zuvor gemessenen maximalen) Stärke des Magnetfeldes definiert sein. Das Abschalten kann in diesem Fall erfolgen, wenn die Stärke des Magnetfeldes um mehr als den Schwellwert abgenommen hat. Alternativ kann der Schwellwert bezüglich der Stärke absolut definiert sein. Das Abschalten kann in diesem Fall erfolgen, wenn die Stärke des Magnetfeldes den Schwellwert unterschreitet.

Der Gradient kann ein räumlicher oder ein zeitlicher Gradient sein. Der Gradient kann auch ein zeitlicher Gradient eines räumlichen Gradienten der Stärke des Magnetfeldes sein. Der Schwellwert bezüglich des räumlichen Gradienten kann relativ zum ursprünglichen räumlichen Gradienten oder absolut definiert sein. Bei einem relativ definierten Schwellwert für den räumlichen Gradienten kann das Abschalten erfolgen, wenn der räumliche Gradient (betragsmäßig) um mehr als den Schwellwert abgenommen hat. Bei einem absolut definierten Schwellwert für den räumlichen Gradienten kann das Abschalten erfolgen, wenn der räumliche Gradient, insbesondere betragsmäßig, den Schwellwert unterschreitet. Der Schwellwert für einen der zeitlichen Gradienten ist typischerweise absolut definiert.

Es kann jeweils ein weiterer Schwellwert festgelegt sein, so dass das Abschalten nur erfolgt, wenn sich die betrachtete Messgröße (Stärke des Magnetfeldes bzw. einer der Gradienten) in einem Bereich zwischen den Schwellwerten befindet. Ein weiterer Schwellwert kann insbesondere für einen zeitlichen Gradienten vorgesehen sein.

Um eine das Abschalten auslösende Abnahme des Magnetfeldes festzustellen kann überprüft werden, ob einzelne oder mehrere der vorgenannten Schwellwerte passiert (je nach Schwellwert über- oder unterschritten) wurden. Das Abschalten kann mit anderen Worten von mehreren Bedingungen abhängig gemacht werden, von denen alle oder zumindest eine bestimmte Anzahl erfüllt sein müssen.

Es kann vorgesehen sein, dass die Laserlichtquelle nur dann abgeschaltet wird, wenn die Abnahme der Stärke des Magnetfeldes in ihrem zeitlichen Verlauf einer thermisch bedingten Entmagnetisierung des Permanentmagneten entspricht. Ein Verbringen des Haltearms in die Freigabestellung führt zu einer in ihrem zeitlichen Verlauf anderen Abnahme des von dem ersten Magnetfeldsensor erfassten Magnetfeldes. Es können sich insbesondere ein zeitlicher Gradient und/oder der Endwert der Stärke des Magnetfelds unterscheiden. Ein (gewolltes) Öffnen des Strahlverschlusses kann daher von einem (ungewollten) Durchbrennen des Haltearms mit Überhitzung des Permanentmagneten unterschieden werden, da sich die hierfür jeweils charakteristischen zeitlichen Verläufe der Stärke des Magnetfelds unterscheiden.

Besonders bevorzugt ist an dem Grundkörper des Strahlverschlusses der Laseranordnung ein zweiter Magnetfeldsensor angeordnet ist, wobei in der Freigabestellung des Haltearms der Permanentmagnet näher an dem zweiten Magnetfeldsensor angeordnet ist als in der Verschlussstellung des Haltearms. Es kann vorgesehen sein, dass die Laserlichtquelle nur dann abgeschaltet wird, wenn die Stärke eines von dem zweiten Magnetfeldsensor gemessenen Magnetfelds nicht zunimmt. Eine Zunahme der Stärke des von dem zweiten Magnetfeldsensor gemessenen Magnetfelds signalisiert ein gewolltes Öffnen des Strahlverschlusses (Verbringen des Haltearms in die Freigabestellung). Ein Abschalten der Laserlichtquelle ist in diesem Fall nicht erforderlich.

Weitere Vorteile und vorteilhafte Ausgestaltungen des Gegenstands der Erfindung ergeben sich aus der Beschreibung, den Ansprüchen und der Zeichnung. Die vorstehend genannten und die noch weiter aufgeführten Merkmale können je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung dargestellt und wird anhand von Ausführungsbeispielen näher erläutert. Es zeigen:
- Fig. 1: eine Laseranordnung mit einem Strahlverschluss, wobei ein Haltearm mit einer reflektierenden Optik in einer Verschlussstellung in den Strahlengang eines Laserstrahls eingeklappt ist, in einer schematischen Darstellung;
- Fig. 2: die Laseranordnung von Fig. 1, wobei der Haltearm in eine Freigabestellung verbracht ist, so dass der Laserstrahl nicht auf die reflektierende Optik trifft, in einer schematischen Darstellung;
- Fig. 3: eine Sensorbaugruppe mit zwei Magnetfeldsensoren des Strahlverschlusses der Laseranordnung gemäß Fig. 1 und 2, in einer schematischen Darstellung;
- Fig. 4: eine Sensorbaugruppe, bei der ein erster Magnetfeldsensor vier Subsensoren umfasst, in einer schematischen Darstellung;
- Fig. 5: ein Ablaufdiagramm eines Betriebsverfahrens für eine Laseranordnung.

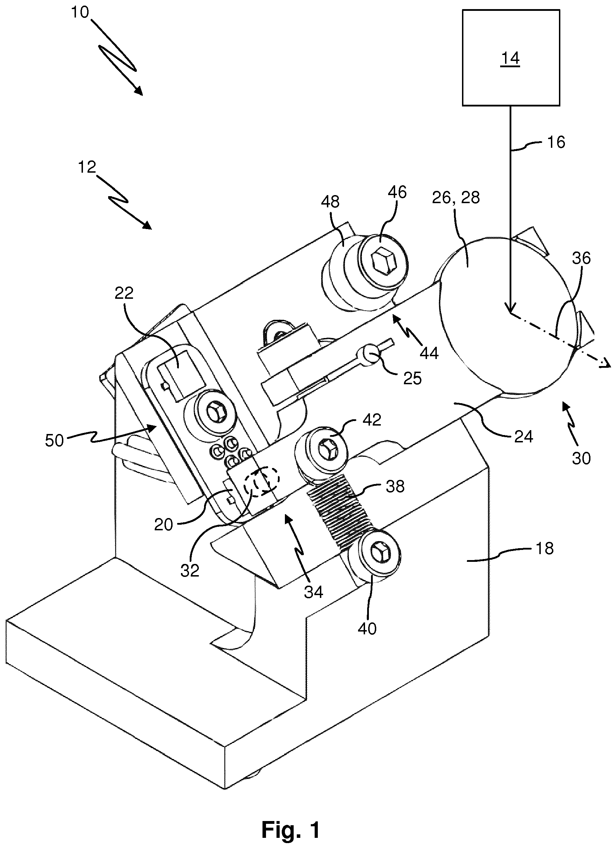

**Figur 1** zeigt eine erfindungsgemäße Laseranordnung 10. Die Laseranordnung 10 umfasst einen erfindungsgemäßen Strahlverschluss 12 und eine Laserlichtquelle 14. Die Laserlichtquelle 14 sendet im Betrieb einen Laserstrahl 16 aus.

Der Strahlverschluss 12 weist einen Grundkörper **18** auf. An dem Grundkörper 18 ist ein erster Magnetfeldsensor **20** angeordnet. Ferner ist an dem Grundkörper 18 ein zweiter Magnetfeldsensor **22** angeordnet. Die beiden Magnetfeldsensoren 20, 22 sind hier jeweils als ein Hall-Sensor ausgebildet. Die Magnetfeldsensoren 20, 22 messen im Betrieb jeweils die Stärke eines auf sie wirkenden Magnetfeldes. Das Messergebnis wird an eine nicht dargestellte Steuereinheit der Laseranordnung 10 übermittelt.

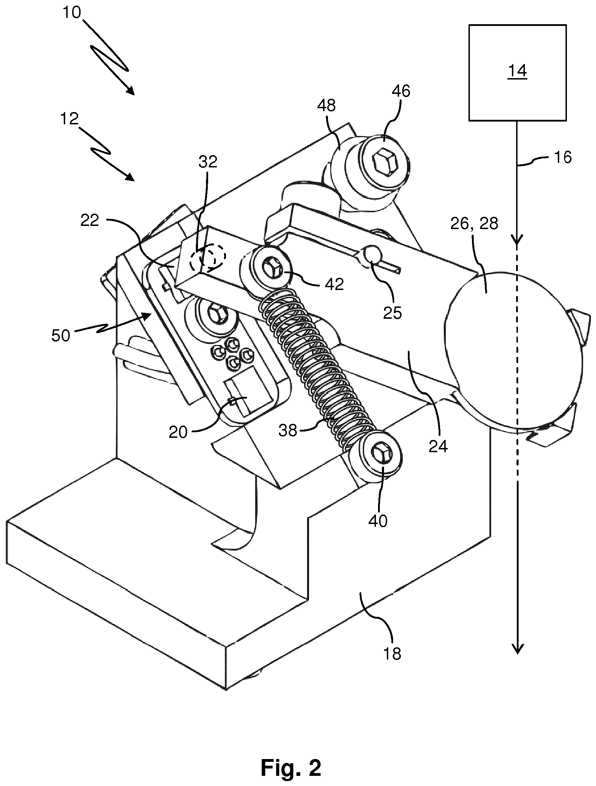

Der Strahlverschluss 12 weist einen Haltearm **24** auf. Der Haltearm 24 kann aus CuCr1Zr bestehen. Der Haltearm 24 ist relativ zu dem Grundkörper 18 beweglich gelagert. Hier ist der Haltearm 24 an einer Ausgangswelle 25 eines im Grundkörper 18 angeordneten Schrittmotors (nicht dargestellt) befestigt. Der Haltearm 24 ist in Figur 1 in einer Verschlussstellung gezeigt. Durch Drehen mittels des Schrittmotors kann der Haltearm 24 in eine in **Figur 2** gezeigte Freigabestellung überführt werden.

An dem Haltearm 24 ist eine reflektierende Optik 26 angeordnet. Die reflektierende Optik 26 umfasst hier einen Spiegel 28. Der Spiegel 28 ist in einem ersten Endbereich 30 des Haltearms 24 mit dem Haltearm 24 verklebt. Der Haltearm 24 hintergreift die reflektierende Optik 26 flächig. Hinter dem Spiegel 28 ist mit anderen Worten ein durchgehender Flächenabschnitt (verdeckt) des Haltearms 24 ausgebildet.

An dem Haltearm 24 ist ein Permanentmagnet 32 angeordnet. Der Permanentmagnet 32 ist beabstandet von der reflektierenden Optik 26 in einem dem ersten Endbereich 30 gegenüberliegenden zweiten Endbereich 34 an dem Haltearm 24 befestigt. Eine Drehachse (vgl. Ausgangswelle 25) des Haltearms 24 verläuft zwischen der reflektierenden Optik 26 und dem Permanentmagneten 32. Der Permanentmagnet 32 erzeugt ein Magnetfeld. Bei Erwärmen des Permanentmagneten 32 über eine erste Grenztemperatur nimmt eine Stärke des Magnetfeldes ab. Insbesondere verschwindet bei Erwärmen des Permanentmagneten 32 über eine zweite Grenztemperatur, die hier seine Curie-Temperatur ist, das von ihm erzeugte Magnetfeld vollständig. Die Curie-Temperatur des Permanentmagneten liegt hier mehr als 400 K unter der Schmelztemperatur des Haltearms 24.

In der in Figur 1 gezeigten Verschlussstellung des Haltearms 24 ist der Permanentmagnet 32 in unmittelbarer Nähe zum ersten Magnetfeldsensor 20 angeordnet. Der Permanentmagnet 32 ist in der Verschlussstellung deutlich weiter von dem zweiten Magnetfeldsensor 22 entfernt.

In der in Figur 2 gezeigten Freigabestellung des Haltearms 24 ist der Permanentmagnet 32 in unmittelbarer Nähe des zweiten Magnetfeldsensors 22 angeordnet. Der Permanentmagnet 32 ist in der Freigabestellung deutlich weiter von dem ersten Magnetfeldsensor 20 entfernt.

Der jeweils nahe an dem Permanentmagneten 32 befindliche Magnetfeldsensor 20 bzw. 22 erfasst das von dem Permanentmagneten 32 erzeugte Magnetfeld, sofern der Permanentmagnet 32 nicht überhitzt wurde. Anhand der Sensorsignale der Magnetfeldsensoren 20, 22 kann daher festgestellt werden, ob sich der Haltearm 24 in der Verschlussstellung oder in der Freigabestellung befindet.

Wenn der Permanentmagnet 32 über seine erste Grenztemperatur, insbesondere über seine zweite Grenztemperatur, erhitzt wird, erfassen die Magnetfeldsensoren 20, 22 nur ein schwaches oder gar kein Magnetfeld. Diese Information erlaubt die Schlussfolgerung, dass der Permanentmagnet 32 und auch der Haltearm 24 überhitzt sind. Die Laserlichtquelle 14 muss dann aus Sicherheitsgründen abgeschaltet werden.

In der Verschlussstellung des Haltearms 24 (vgl. Figur 1) trifft der Laserstrahl 16 auf die reflektierende Optik 26. Er wird von der reflektierenden Optik 26 zu einem nicht dargestellten Absorber abgelenkt, vgl. strichpunktierter Pfeil 36. Der Haltearm 24 mit der reflektierenden Optik 26 ist mit anderen Worten im Strahlengang des Laserstrahls 16 angeordnet.

Der Haltearm 24 ist hier so ausgebildet, dass er dem Auftreffen des Laserstrahls 16 auch dann standhält und diesen unterbricht, wenn aus irgendwelchen Gründen die reflektierende Optik 26 beschädigt sein sollte, insbesondere wenn sich der Spiegel 28 von dem Haltearm 24 gelöst haben sollte. Der Haltearm 24 hält dem Laserstrahl 16 so lange stand, bis der Permanentmagnet 32 über die erste Grenztemperatur, insbesondere über die zweite Grenztemperatur, erwärmt wurde. Die Materialien des Halterarms 24 und des Permanentmagneten 32 sind so gewählt, dass bis zu diesem Zeitpunkt der Haltearm 42 nicht bis zu seiner Schmelztemperatur erwärmt wurde. Der Defekt der reflektierenden Optik 26 kann somit durch Auswerten der Signale der Magnetfeldsensoren 20, 22, insbesondere durch Auswerten des Signals des ersten Magnetfeldsensors 20, detektiert werden, bevor es zu einem ungewollten Austreten des Laserstrahls 16 aus der Laseranordnung 10 kommen kann. Die Laserlichtquelle 14 wird bei Feststellung des Defekts automatisch abgeschaltet.

In der Freigabestellung (vgl. Figur 2) ist der Haltearm 24 mit der reflektierenden Optik 26 außerhalb des Strahlengangs der Laserlichtquelle 14 angeordnet. Der Laserstrahl 16 verläuft in der dargestellten Konfiguration hinter dem Halterarm 24 vorbei (vgl. gestrichelter Abschnitt des Laserstrahls 16), so dass er unten aus der Laseranordnung 10 austreten kann. In der Freigabestellung des Halterarms 24 kann beispielsweise eine Bearbeitung eines Werkstücks mit dem Laserstrahl 16 durchgeführt werden.

Der Haltearm 24 ist bei dem dargestellten Strahlverschluss 12 in die Verschlussstellung vorgespannt. Hierzu ist eine Feder **38** mit Schrauben **40**, **42** an dem Grundkörper 18 bzw. dem Haltearm 24 befestigt. Beim Verbringen des Haltearms 24 in die Freigabestellung wird die Feder 38 verlängert, so dass sie in Richtung der Verschlussstellung rückstellend auf den Halterarm 24 wirkt.

An dem Grundkörper 24 ist hier ein Anschlag **44** für den Haltearm 24 vorgesehen. Der Anschlag 44 verhindert ein Verschwenken des Haltearms 24 über die Verschlussstellung hinaus. Der Anschlag 44 ist hier durch eine weitere Schraube **46** mit einem daran angeordneten Gummiring **48** gebildet.

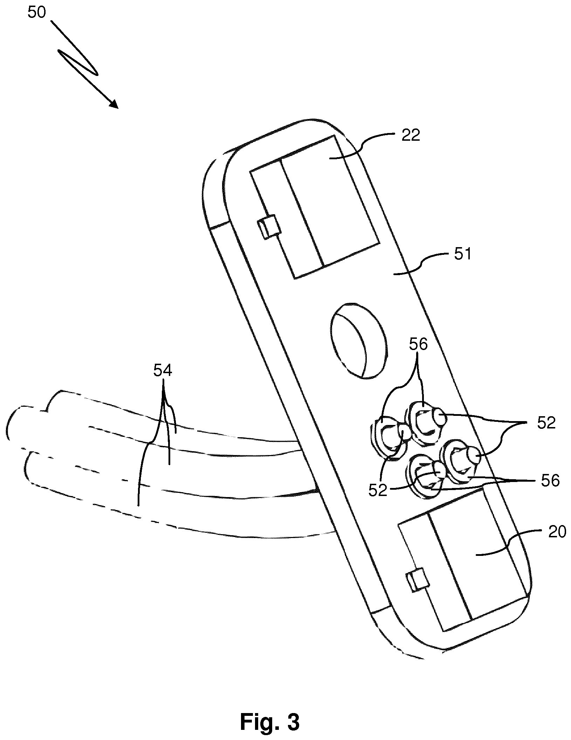

**Figur 3** zeigt eine Sensorbaugruppe **50** des Strahlverschlusses 12 von Figur 1 und 2. Die Sensorbaugruppe 50 umfasst die beiden Magnetfeldsensoren 20, 22, die auf einer gemeinsamen Platine **51** angeordnet sind. Zum Übermitteln der Signale der beiden Magnetfeldsensoren 20, 22 sind Adern **52** von vier Kabeln **54** von hinten durch ringförmige Lötkontakte **56** der Platine 51 gesteckt und in nicht näher dargestellter Weise von vorne mit den Lötkontakten 56 verlötet. Je zwei der Lötkontakte 56 sind in nicht dargestellter Weise durch Leiterbahnen innerhalb der Platine 51 mit je einem der Magnetfeldsensoren 20 bzw. 22 verbunden. Die Sensorbaugruppe 50 wird mit dem Grundkörper 18 des Strahlverschlusses 12 verschraubt, vgl. Figuren 1 und 2.

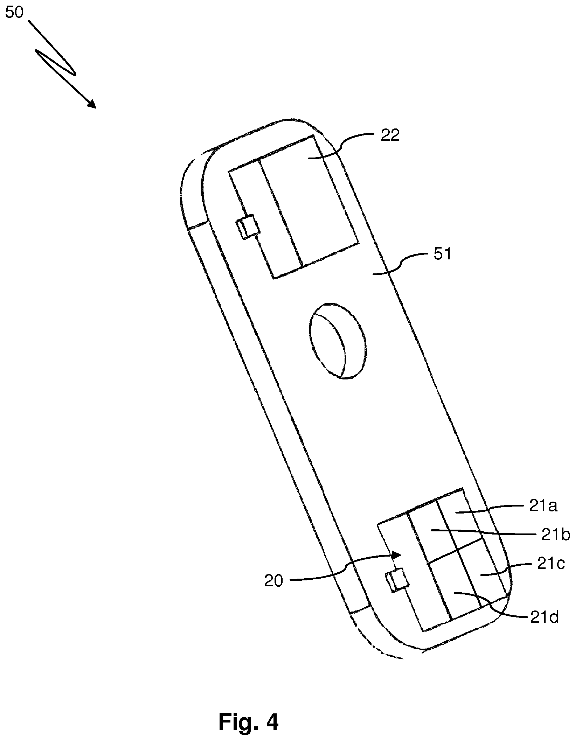

**Figur 4** zeigt eine alternative Bauform einer Sensorbaugruppe 50 für den Strahlverschluss 12. Der erste Magnetfeldsensor 20 ist bei dieser Sensorbaugruppe 50 als ein Sensorarray mit mehreren, hier vier, Subsensoren **21a-21d** ausgebildet. Die Subsensoren 21a-21d ermöglichen es, einen räumlichen Gradienten eines Magnetfeldes zu erfassen. Die vier Subsensoren 21a-21d sind in einer Matrixstruktur von zwei Zeilen (mit den Subsensoren 21a und 21b in der ersten Zeile und den Subsensoren 21c und 21d in der zweiten Zeile) und zwei Spalten (mit den Subsensoren 21a und 21c in der ersten Spalte und den Subsensoren 21b und 21d in der zweiten Spalte) angeordnet. Es könnten insbesondere auch mehr als zwei Zeilen vorgesehen sein. Bei einer Bewegung des Permanentmagneten 32 von der Verschlussstellung in die Freigabestellung, vgl. Figuren 1 und 2, bewegt sich der Permanentmagnet 32 relativ zu den Subsensoren 21a-21d in unterschiedlicher Weise, so dass eine Bewegung des Permanentmagneten 32 über den Signalverlauf an den einzelnen Subsensoren 21a-21d von einer Entmagnetisierung des Permanentmagneten 32 unterschieden werden kann.

Auch der zweite Magnetfeldsensor 22 könnte mehrere Subsensoren aufweisen (nicht näher dargestellt).

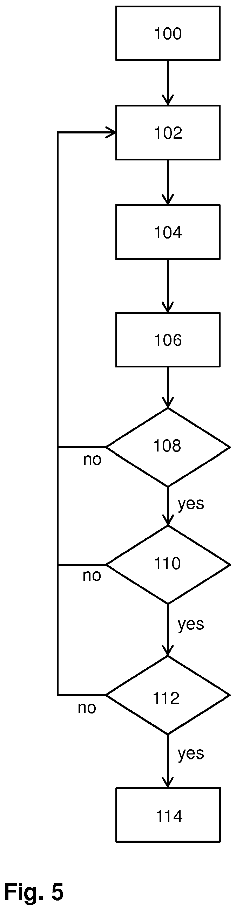

**Figur 5** zeigt ein Ablaufdiagramm eines erfindungsgemäßen Betriebsverfahrens für die Laseranordnung 10 von Figur 1 und 2.

In einem Schritt **100** wird der Haltearm 24 des Strahlverschlusses 12 in die Verschlussstellung (vgl. Figur 1) verbracht. Während sich der Haltearm 24 in der Verschlussstellung befindet, wird die Laserlichtquelle 14 betrieben (Schritt **102**), so dass sie den Laserstrahl 16 aussendet. Der Betrieb der Laserlichtquelle 14 kann vor der Durchführung von Schritt 100 begonnen haben. Während des Betriebs 102 der Laserlichtquelle 14 wird die Stärke und optional ein zeitlicher Gradient des von dem Permanentmagneten 32 erzeugten Magnetfelds von dem ersten Magnetfeldsensor 20 gemessen (Schritt **104**). Das Messen der Stärke und ggf. des zeitlichen Gradienten des Magnetfelds kann in geringen Zeitabständen oder vorzugsweise kontinuierlich erfolgen.

Im Folgenden wird angenommen, dass sich die reflektierende Optik 26 von dem Halterarm 24 gelöst habe, so dass der Laserstrahl 16 direkt auf den Haltearm 24 trifft. Dadurch wird der Haltearm 24 erwärmt. Der Haltearm 24 leitet die Wärme zu dem Permanentmagneten 32 weiter, so dass auch dieser erwärmt wird (Schritt **106**). Bei ausreichend langer Einwirkung des Laserstrahls 16 mit entsprechender Leistung auf den Haltearm 24 wird der Permanentmagnet 32 bis über die erste Grenztemperatur, insbesondere über die zweite Grenztemperatur, erwärmt. Aufgrund dieser Überhitzung des Permanentmagneten 32 nimmt die Stärke des von dem Permanentmagneten 32 erzeugten Magnetfelds ab. Die Abnahme des Magnetfelds wird von dem ersten Magnetfeldsensor 20 erfasst.

Das Betriebsverfahren sieht eine Abfrage **108** vor, ob das von dem ersten Magnetfeldsensor 20 gemessene Magnetfeld abgenommen hat. Falls nein, befindet sich der Strahlverschluss 12 noch in einem sicheren Zustand (Haltearm 24 in Verschlussstellung und nicht überhitzt), so dass die Laserlichtquelle 14 weiter betrieben werden kann.

Im beschriebenen Beispiel wurde angenommen, dass das Magnetfeld am ersten Magnetfeldsensor 20 abgenommen hat. Aus der Geschwindigkeit der Abnahme erkennt die Steuereinheit, dass es sich um eine thermisch bedingte Entmagnetisierung des Permanentmagneten 32 handelt. Die Geschwindigkeit der Abnahme der Stärke des Magnetfeldes kann mittels eines zeitlichen Gradienten erfasst werden. Gleichzeitig stellt die Steuereinheit fest, dass das von dem zweiten Magnetfeldsensor 22 erfasste Magnetfeld nicht zunimmt. Das Betriebsverfahren sieht Abfragen **110** und **112** für diese beiden Bedingungen vor. Wenn beide Bedingungen 110, 112 erfüllt sind, schaltet die Steuereinheit in einem Schritt **114** die Laserlichtquelle 14 ab. Andernfalls kann die Laserlichtquelle 14 weiter betrieben werden, da der Haltearm 24 gewollt in die Freigabestellung verbracht wurde.

Es sei angemerkt, dass in Varianten des Verfahrens auch nur eine der beiden Bedingungen 110 bzw. 112 abgefragt werden könnte. Insbesondere kann bei einem Strahlverschluss 12 mit zwei Magnetfeldsensoren 20, 22 zugunsten der robusteren Abfrage des zweiten Magnetfeldsensors 22 auf die anspruchsvollere Auswertung des zeitlichen Verlaufs des Signals des ersten Magnetfeldsensors 20 verzichtet werden. Alternativ könnte auf den zweiten Magnetfeldsensor 22 verzichtet werden und nur aus dem zeitlichen Verlauf des Signals des ersten Magnetfeldsensors 20 auf das Durchbrennen bzw. Verbringen in die Freigabestellung des Haltearms 24 geschlossen werden.

### Bezugszeichenliste:

Laseranordnung 10
Strahlverschluss 12
Laserlichtquelle 14
Laserstrahl 16
Grundkörper 18
erster Magnetfeldsensor 20
Subsensoren 21a-21d
zweiter Magnetfeldsensor 22
Haltearm 24
Ausgangswelle 25
reflektierende Optik 26
Spiegel 28
erster Endbereich 30
Permanentmagnet 32
zweiter Endbereich 34
Pfeil 36
Feder 38
Schrauben 40, 42
Anschlag 44
Schraube 46
Gummiring 48
Sensorbaugruppe 50
Platine 51
Adern 52
Kabel 54
Lötkontakte 56
Verbringen 100 des Haltearms 24 in die Verschlussstellung
Betreiben 102 der Laserlichtquelle 14
Messen 104 eines Magnetfelds mit dem ersten Magnetfeldsensor 20
Erwärmen 106 des Permanentmagneten 32
Abfrage 108: Magnetfeld am ersten Magnetfeldsensor 20 nimmt ab?
Abfrage 110: Thermisch bedingte Entmagnetisierung?
Abfrage 112: Magnetfeld am zweiten Magnetfeldsensor 22 nimmt nicht zu?
Abschalten 114 der Laserlichtquelle 14

## Patentansprüche

1. Strahlverschluss (12) für einen Laserstrahl (16) aufweisend
- einen Grundkörper (18), an dem ein erster Magnetfeldsensor (20) angeordnet ist, und
- einen relativ zu dem Grundkörper (18) in eine Freigabestellung und eine Verschlussstellung verbringbaren Haltearm (24), an dem eine reflektierende Optik (26) zum Umlenken des Laserstrahls (16) und ein Permanentmagnet (32), der ein Magnetfeld erzeugt, dessen Stärke bei Erwärmen des Permanentmagneten (32) über eine erste Grenztemperatur abnimmt, angeordnet sind,
wobei in der Verschlussstellung des Haltearms (24) der Permanentmagnet (32) näher an dem ersten Magnetfeldsensor (20) angeordnet ist als in der Freigabestellung des Haltearms (24), und
wobei der Strahlverschluss (12) eine Steuereinheit aufweist, welche dazu eingerichtet ist, eine Laserlichtquelle (14) abzuschalten, wenn das von dem ersten Magnetfeldsensor (20) gemessene Magnetfeld abnimmt, wobei ein vorbestimmter Schwellwert bezüglich der Stärke und/oder des Gradienten des Magnetfelds passiert werden.

2. Strahlverschluss nach Anspruch 1, **dadurch gekennzeichnet, dass** das Magnetfeld bei Erwärmen des Permanentmagneten (32) über eine zweite Grenztemperatur, die insbesondere eine Curie-Temperatur des Permanentmagneten (32) ist, vollständig verschwindet.

3. Strahlverschluss nach Anspruch 2, **dadurch gekennzeichnet, dass** die zweite Grenztemperatur des Permanentmagneten (32) unter der Schmelztemperatur eines Materials des Haltearms (24) liegt, vorzugsweise wenigstens 200 K, besonders bevorzugt wenigstens 300 K, ganz besonders bevorzugt wenigstens 400 K.

4. Strahlverschluss nach einem der vorhergehenden Ansprüche, **dadurch gekennzeichnet, dass** der Haltearm (24) aus CuCr1Zr besteht.

5. Strahlverschluss nach einem der vorhergehenden Ansprüche, **dadurch gekennzeichnet, dass** der Haltearm (24) in die Verschlussstellung vorgespannt ist.

6. Strahlverschluss nach einem der vorhergehenden Ansprüche, **dadurch gekennzeichnet, dass** der Haltearm (24) drehbar an dem Grundkörper (18) gelagert ist.

7. Strahlverschluss nach einem der vorhergehenden Ansprüche, **dadurch gekennzeichnet, dass** die reflektierende Optik (26) einen Spiegel (28) aufweist, der vorzugsweise mit dem Haltearm (24) verklebt ist.

8. Strahlverschluss nach einem der vorhergehenden Ansprüche, **dadurch gekennzeichnet, dass** der erste Magnetfeldsensor (20) als ein Hall-Sensor ausgebildet ist.

9. Strahlverschluss nach einem der vorhergehenden Ansprüche, **dadurch gekennzeichnet, dass** an dem Grundkörper (18) ein zweiter Magnetfeldsensor (22) angeordnet ist, und dass in der Freigabestellung des Haltearms (24) der Permanentmagnet (32) näher an dem zweiten Magnetfeldsensor (22) angeordnet ist als in der Verschlussstellung des Haltearms (24).

10. Laseranordnung (10) mit einer Laserlichtquelle (14) zum Erzeugen eines Laserstrahls (16) und mit einem im Strahlengang des Laserstrahls (16) angeordneten Strahlverschluss (12) nach einem der vorhergehenden Ansprüche, wobei der Laserstrahl (16) in der Verschlussstellung des Haltearms (24) auf die reflektierende Optik (26) trifft.

11. Laseranordnung nach Anspruch 10, **dadurch gekennzeichnet, dass** der Haltearm (24) des Strahlverschlusses (12) die reflektierende Optik (26) flächig hintergreift und so ausgebildet ist, dass er bei Fehlen der reflektierenden Optik (26) einem unmittelbaren Auftreffen des Laserstrahls (16) standhält, bis der Permanentmagnet (32) über die erste Grenztemperatur, insbesondere über die zweite Grenztemperatur, erwärmt worden ist.

12. Verfahren zum Betreiben einer Laseranordnung (10) nach Anspruch 10 oder 11, mit den Schritten
a) Verbringen (100) des Haltearms (24) in die Verschlussstellung,
b) Betreiben (102) der Laserlichtquelle (14) und Messen (104) einer Stärke und/oder eines Gradienten eines Magnetfeldes mit dem ersten Magnetfeldsensor (20),
c) Abschalten (114) der Laserlichtquelle (14), wenn das von dem ersten Magnetfeldsensor (20) gemessene Magnetfeld abnimmt, wobei ein vorbestimmter Schwellwert bezüglich der Stärke und/oder des Gradienten des Magnetfelds passiert werden.

13. Verfahren nach Anspruch 12 **dadurch gekennzeichnet, dass** im Schritt b) der Permanentmagnet (32) über die erste Grenztemperatur, insbesondere über die zweite Grenztemperatur, erwärmt wird.

14. Verfahren nach Anspruch 12 oder 13, **dadurch gekennzeichnet, dass** die Laserlichtquelle (14) nur dann abgeschaltet wird, wenn die Abnahme der Stärke des Magnetfeldes in ihrem zeitlichen Verlauf einer thermisch bedingten Entmagnetisierung des Permanentmagneten (32) entspricht.

15. Verfahren nach einem der Ansprüche 12 bis 14, **dadurch gekennzeichnet, dass** der Strahlverschluss (12) gemäß Anspruch 9 ausgebildet ist, und dass die Laserlichtquelle (14) nur dann abgeschaltet wird, wenn die Stärke eines von dem zweiten Magnetfeldsensor (22) gemessenen Magnetfelds nicht zunimmt.

## Claims

1. Beam shutter (12) for a laser beam (16) comprising
- a base body (18) on which a first magnetic field sensor (20) is arranged, and
- a holding arm (24) which can be moved relative to the base body (18) into a release position and into a closing position, on which are arranged a reflecting optics (26) for deflecting the laser beam (16) and a permanent magnet (32), which generates a magnetic field whose strength decreases when the permanent magnet (32) is heated above a first limit temperature,
wherein in the closing position of the holding arm (24) the permanent magnet (32) is arranged closer to the first magnetic field sensor (20) than in the release position of the holding arm (24), and
wherein the beam shutter (12) comprises a control unit which is adapted to switch off a laser light source (14) when the magnetic field measured by the first magnetic field sensor (20) decreases, wherein a predetermined threshold value regarding the strength and/or the gradient of the magnetic field is passed.

2. Beam shutter according to claim 1, **characterized in that** the magnetic field disappears completely when the permanent magnet (32) is heated above a second limit temperature, which is in particular a Curie temperature of the permanent magnet (32).

3. Beam shutter according to claim 2, **characterized in that** the second limit temperature of the permanent magnet (32) is below the melting temperature of a material of the holding arm (24), preferably at least 200 K, more preferably at least 300 K, most preferably at least 400 K.

4. Beam shutter according to any one of the preceding claims, **characterized in that** the holding arm (24) is made of CuCr1Zr.

5. Beam shutter according to any one of the preceding claims, **characterized in that** the holding arm (24) is pretensioned into the closing position.

6. Beam shutter according to any one of the preceding claims, **characterized in that** the holding arm (24) is rotatably mounted on the base body (18).

7. Beam shutter according to any one of the preceding claims, **characterized in that** the reflecting optics (26) comprises a mirror (28) which is preferably glued to the holding arm (24).

8. Beam shutter according to any one of the preceding claims, **characterized in that** the first magnetic field sensor (20) is designed as a Hall sensor.

9. Beam shutter according to any one of the preceding claims, **characterized in that** a second magnetic field sensor (22) is arranged on the base body (18), and **in that** in the release position of the holding arm (24) the permanent magnet (32) is arranged closer to the second magnetic field sensor (22) than in the closing position of the holding arm (24).

10. Laser arrangement (10) having a laser light source (14) for generating a laser beam (16) and having a beam shutter (12) according to one of the preceding claims arranged in the beam path of the laser beam (16), wherein the laser beam (16) impacts on the reflective optics (26) in the closing position of the holding arm (24).

11. Laser arrangement according to claim 10, **characterized in that** the holding arm (24) of the beam shutter (12) engages behind the reflecting optics (26) in a planar manner and is designed in such a way that, in the absence of the reflecting optics (26), it withstands direct impact of the laser beam (16) until the permanent magnet (32) has been heated above the first limit temperature, in particular above the second limit temperature.

12. Method of operating a laser arrangement (10) according to claim 10 or 11, comprising the steps of
a) moving (100) the holding arm (24) into the closing position,
b) operating (102) the laser light source (14) and measuring (104) a strength and/or a gradient of a magnetic field with the first magnetic field sensor (20),
c) turning off (114) the laser light source (14) when the magnetic field measured by the first magnetic field sensor (20) decreases, wherein a predetermined threshold value with respect to the strength and/or the gradient of the magnetic field is passed.

13. Method according to claim 12, **characterized in that** in step b) the permanent magnet (32) is heated above the first limit temperature, in particular above the second limit temperature.

14. Method according to claim 12 or 13, **characterized in that** the laser light source (14) is switched off only if the decrease in strength of the magnetic field in its temporal course corresponds to demagnetization of the permanent magnet (32) due to thermal factors.

15. Method according to any one of claims 12 to 14, **characterized in that** the beam shutter (12) is formed according to claim 9, and **in that** the laser light source (14) is switched off only when the strength of a magnetic field measured by the second magnetic field sensor (22) does not increase.

## Revendications

1. Obturateur de faisceau (12) pour un faisceau laser (16), présentant
- un corps de base (18) sur lequel est disposé un premier capteur de champ magnétique (20), et
- un bras de maintien (24) pouvant être amené dans une position de libération et une position de fermeture par rapport au corps de base (18) et au niveau duquel sont disposés un système optique réfléchissant (26) permettant de dévier le faisceau laser (16) et un aimant permanent (32) produisant un champ magnétique dont l'intensité diminue lorsque l'aimant permanent (32) est chauffé au-delà d'une première température limite,
l'aimant permanent (32) dans la position de fermeture du bras de maintien (24) étant disposé plus près du premier capteur de champ magnétique (20) que dans la position de libération du bras de maintien (24), et
l'obturateur de faisceau (12) présentant une unité de commande qui est conçue pour désactiver une source de lumière laser (14) si le champ magnétique mesuré par le premier capteur de champ magnétique (20) diminue,
une valeur seuil prédéterminée concernant l'intensité et/ou le gradient du champ magnétique étant franchie.

2. Obturateur de faisceau selon la revendication 1, **caractérisé en ce que** le champ magnétique disparaît complètement lorsque l'aimant permanent (32) est chauffé au-delà d'une deuxième température limite qui est en particulier la température de Curie de l'aimant permanent (32) .

3. Obturateur de faisceau selon la revendication 2, **caractérisé en ce que** la deuxième température limite de l'aimant permanent (32) est inférieure à la température de fusion d'un matériau du bras de maintien (24), de préférence égale à au moins 200 K, de manière particulièrement préférée à au moins 300 K, de manière tout particulièrement préférée à au moins 400 K.

4. Obturateur de faisceau selon l'une quelconque des revendications précédentes, **caractérisé en ce que** le bras de maintien (24) est composé de CuCr1Zr.

5. Obturateur de faisceau selon l'une quelconque des revendications précédentes, **caractérisé en ce que** le bras de maintien (24) est précontraint dans la position de fermeture.

6. Obturateur de faisceau selon l'une quelconque des revendications précédentes, **caractérisé en ce que** le bras de maintien (24) est monté pivotant sur le corps de base (18) .

7. Obturateur de faisceau selon l'une quelconque des revendications précédentes, **caractérisé en ce que** le système optique réfléchissant (26) présente un miroir (28) qui est collé de préférence au bras de maintien (24) .

8. Obturateur de faisceau selon l'une quelconque des revendications précédentes, **caractérisé en ce que** le premier capteur de champ magnétique (20) est réalisé sous forme de capteur à effet Hall.

9. Obturateur de faisceau selon l'une quelconque des revendications précédentes, **caractérisé en ce qu'**un deuxième capteur de champ magnétique (22) est disposé sur le corps de base (18), et **en ce que** l'aimant permanent (32), dans la position de libération du bras de maintien (24), est disposé plus près du deuxième capteur de champ magnétique (22) que dans la position de fermeture du bras de maintien (24).

10. Agencement laser (10), comprenant une source de lumière laser (14) permettant de produire un faisceau laser (16) et comprenant un obturateur de faisceau (12) selon l'une quelconque des revendications précédentes disposé dans le trajet optique du faisceau laser (16), le faisceau laser (16) étant incident sur le système optique réfléchissant (26) dans la position de fermeture du bras de maintien (24).

11. Agencement laser selon la revendication 10, **caractérisé en ce que** le bras de maintien (24) de l'obturateur de faisceau (12) saisit par l'arrière le système optique réfléchissant (26) de manière plane, et **en ce qu'**il est réalisé de telle sorte qu'en l'absence du système optique réfléchissant (26), il résiste à une incidence directe du faisceau laser (16) jusqu'à ce que l'aimant permanent (32) ait été chauffé au-delà de la première température limite, en particulier au-delà de la deuxième température limite.

12. Procédé permettant de faire fonctionner un agencement laser (10) selon la revendication 10 ou 11, comprenant les étapes consistant à
a) amener (100) le bras de maintien (24) dans la position de fermeture,
b) faire fonctionner (102) la source de lumière laser (14) et mesurer (104) par le premier capteur de champ magnétique (20) une intensité et/ou un gradient d'un champ magnétique,
c) désactiver (114) la source de lumière laser (14) si le champ magnétique mesuré par le premier capteur de champ magnétique (20) diminue, une valeur seuil prédéterminée concernant l'intensité et/ou le gradient du champ magnétique étant franchie.

13. Procédé selon la revendication 12, **caractérisé en ce qu'**à l'étape b), l'aimant permanent (32) est chauffé au-delà de la première température limite, en particulier au-delà de la deuxième température limite.

14. Procédé selon la revendication 12 ou 13, **caractérisé en ce que** la source de lumière laser (14) n'est désactivée que si la diminution de l'intensité du champ magnétique correspond au niveau de son évolution dans le temps à une désaimantation de l'aimant permanent (32) due à des phénomènes thermiques.

15. Procédé selon l'une quelconque des revendications 12 à 14, **caractérisé en ce que** l'obturateur de faisceau (12) est réalisé selon la revendication 9, et **en ce que** la source de lumière laser (14) n'est désactivée que si l'intensité d'un champ magnétique mesuré par le deuxième capteur de champ magnétique (22) n'augmente pas.
